# EUROPÄISCHE PATENTSCHRIFT

(11) **EP 2 444 373 B1**
(45) Veröffentlichungstag und Bekanntmachung des Hinweises auf die Patenterteilung: **12.12.2012**
(21) Anmeldenummer: 11184964.2
(22) Anmeldetag: 13.10.2011
(51) Int. Cl.: C01B 33/035

(54) **Verfahren zur Herstellung von polykristallinen Siliciumstäben**
Method for producing polycrystalline silicon rods
Procédé de fabrication de tiges de silicium polycristallin

(30) Priorität: 25.10.2010 DE 102010042869
(43) Veröffentlichungstag der Anmeldung: 25.04.2012
(73) Patentinhaber: Wacker Chemie AG, 81737 München (DE)
(72) Erfinder: Fabry, Dr. Laszlo, 84489 Burghausen (DE); Altmann, Thomas, 84533 Haiming (DE); Kraus, Heinz, 84367 Zeilarn (DE)
(74) Vertreter: Killinger, Andreas

(56) Entgegenhaltungen:
- DE-A1-102007 039 638
- DE-B- 1 202 771
- US-A- 3 438 810
- US-A- 5 174 881
- US-A- 5 326 406
- US-A- 5 749 975
- US-A- 6 107 197
- US-B1- 6 503 563

## Beschreibung

Gegenstand der Erfindung ist ein Verfahren zur Herstellung von polykristallinen Siliciumstäben.

Polykristallines Silicium (kurz: Polysilicium) dient als Ausgangsmaterial bei der Herstellung von einkristallinem Silicium mittels Tiegelziehen (Czochralski- oder CZ-Verfahren)- oder mittels Zonenziehen (Floatzone oder FZ-Verfahren). Dieses einkristalline Silicium wird in Scheiben (Wafer) zertrennt und nach einer Vielzahl von mechanischen, chemischen und chemomechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") Dünnstäbe aus Silicium durch direkten Stromdurchgang erhitzt und ein Reaktionsgas enthaltend eine Silicium enthaltende Komponente und Wasserstoff eingeleitet.

Die Silicium-Dünnstäbe weisen üblicherweise eine Kantenlänge von 3 bis 15 mm auf.

Als Silicium enthaltende Komponenten kommen beispielsweise Siliciumhalogenverbindungen wie Siliciumchlorverbindungen, insbesondere Chlorsilane in betracht. Die Silicium enthaltende Komponente wird zusammen mit Wasserstoff in den Reaktor eingeleitet. Bei Temperaturen von mehr als 1000 °C wird auf den Dünnstäben Silicium abgeschieden. Dabei ergibt sich schließlich ein Stab mit polykristallinem Silicium. In DE 1 105 396 sind die Grundprinzipien des Siemens-Prozesses beschrieben.

Bezüglich der Herstellung von Dünnstäben ist aus DE 1 177 119 bekannt, Silicium auf einem Trägerkörper aus Silicium (= Dünnstab) abzuscheiden, anschließend davon einen Teil abzutrennen und diesen abgetrennten Teil wiederum als Trägerkörper für die Abscheidung von Silicium zu verwenden. Das Abtrennen kann mechanisch, z.B. mittels Zersägen, oder elektrolytisch mittels eines Flüssigkeitsstrahls erfolgen.

Beim mechanischen Abtrennen von Dünnstäben wird deren Oberfläche jedoch mit Metallen sowie mit Bor-, Phosphor-, Aluminium- und Arsenverbindungen kontaminiert. Die mittlere Belastung mit B, P, Al und As liegt im Bereich von 60 bis 700 ppta (parts per trillion atomic). Die verunreinigte DünnstabOberfläche belastet die ersten thermisch abgeschiedenen Si-Schichten, indem Dotierstoffe B, P, As auf der Oberfläche der Dünnstäbe während der Abscheidung der ersten Schichten von polykristallinem Silicium auf der Dünnstaboberfläche in den wachsenden Si-Stab eingebaut werden.

Daher ist es üblicherweise nötig, die Dünnstäbe einer Oberflächenreinigung zu unterziehen, bevor sie zur Abscheidung von Silicium verwendet werden können. DE 1 177 119 offenbart diesbezüglich eine Reinigung auf mechanischem Weg, z.B. durch Sandstrahlen, oder auf chemischem Weg durch Ätzen.

Durch Behandlung der Dünnstäbe in einem Ätzbecken aus kontaminationsarmem Material, z.B. Kunststoff, mittels einer Mischung aus HF und HN0₃, lassen sich die Oberflächenkontaminationen deutlich reduzieren, bei B, P, Al und As auf weniger als 15 pptw. Diese Reinheit ist aber für hochohmige FZ-Stäbe nicht ausreichend.

In EP 0 548 504 A2 wird ebenfalls ein Reinigungsverfahren beschrieben, bei dem HF und HN0₃ zur Reinigung von Silicium verwendet werden.

Ein anderes Reinigungsverfahren ist aus DE 195 29 518 Al, bekannt. Dabei wird polykristallines Silicium zuerst mit einer Mischung aus Königswasser (Mischung aus HC1 und HN0₃) gereinigt und dann einer zusätzlichen Reinigung mit HF unterzogen wird.

An Dünnstäbe, die zur Abscheidung von polykristallinen Si-Stäben als Ausgangsmaterial für das Zonenziehen eingesetzt werden, werden besonders hohe Reinheitsanforderungen gestellt. FZ-Dünnstäbe werden US 6,503,563 B1 zufolge nach mechanischer Bearbeitung zuerst mittels HF-HNO₃ geätzt, mit Reinstwasser gespült, getrocknet und anschließend in einem unter Überdruck geschlossenem Inertgasbehälter (N₂, He, bevorzugt Ar) gelagert. in einem späteren Schritt wird kristallines Silicium mittels Plasma-CVD auf dem Dünnstab abgeschieden.

Durch das Handling der Dünnstäbe beim Transport von der HF/HN0₃-Ätzanlage zum Inertgasbehälter und von diesem zum CVD-Reaktor können sich jedoch wieder Dotierstoffe auf der Dünnstaboberfläche ablagern.

Aus DE 27 25 574 A1 ist bekannt, einen Silicium-Träger mittels eines Heizmittels (Wasserstoff, Argon oder Helium) vorzuheizen. Die Gase - in hochreinem Zustand verwendet - verhindern eine Verunreinigung von Silicium. Der Silicium-Träger wird dabei auf eine Temperatur von ca. 400°C erhitzt. Ab dieser Temperatur wird Silicium leitfähig und ermöglicht eine elektrische Beheizung durch Hindurchleiten von elektrischem Strom, jedoch kann unter diesen Bedingungen keine Reinigungswirkung an der Dünnstaboberfläche erzielt werden.

DE 1 202 771 offenbart ein Verfahren, bei dem im Rahmen eines Siemens-Prozesses durch Regelung des Anteils von Halogenwasserstoff im Gasgemisch in einem ersten Schritt eine obere Schicht des Trägerkörpers abgetragen wird und in einem zweiten Schritt Silicium abgeschieden wird. Im ersten Schritt wird der Trägerkörper so lange auf eine Temperatur von etwa 1150°C erhitzt, bis die Oxidhaut reduziert ist.

Aus US 6,107,197 war es bereits bekannt, eine mit Kohlenstoff kontaminierte Siliciumschicht zu entfernen, indem die kontaminierte Schicht Chlor- oder Wasserstoffradikalen ausgesetzt wird, wobei die Chlor- oder Wasserstoffradikale dadurch erzeugt werden, dass Chlor- bzw. Wasserstoffgas an einem erhitzten Filament vorbeigeführt werden. Die Radikale werden dadurch effizienter erzeugt als durch UV-Strahlung. Für eine für Dünnstabreinigung ausreichende Bildung von Wasserstoff und Chlorradikalen wird eine hohe Zersetzungstemperatur über 1000 °C benötigt, wie durch DE 1 202 771 offenbart wurde.

Daher bestand die Aufgabe der Erfindung darin, die oben beschriebenen Nachteile, d. h. hohe Dünnstabtemperatur, durch Handhabung bedingte Verunreinigung der gereinigten Dünnstäbe während der Zwischenlagerung bis zur Abscheidung und nichtausreichende Reinigungswirkung an der Oberfläche der eingebauten Dünnstäben zu vermeiden und den Stand der Technik zu verbessern.

Die Aufgabe wird gelöst durch ein Verfahren zur Herstellung von polykristallinen Siliciumstäben durch Abscheiden von Silicium auf wenigstens einem Dünnstab in einem Reaktor, wobei vor der Siliciumabscheidung Halogenwasserstoff bei einer Dünnstabtemperatur von 400-1000°C in den Reaktor enthaltend wenigstens einen Dünnstab eingeleitet, mittels UV-Licht bestrahlt wird, wodurch Halogen- und Wasserstoffradikale entstehen und die sich bildenden flüchtigen Halogenide aus dem Reaktor entfernt werden.

Vorzugsweise startet die Abscheidung von Silicium auf dem Dünnstab unmittelbar nach dem Reinigungsvorgang mittels Halogen- und Wasserstoffradikalen.

Falls jedoch beabsichtigt ist, die Abscheidung erst zu einem späteren Zeitpunkt durchzuführen, was ebenfalls bevorzugt ist, wird der Dünnstab in einer inerten Atmosphäre gelagert. Dazu eignet sich beispielsweise eine CO₂-Atmosphäre. Ebenso eignen sich als inerte Gase N₂ oder Ar.

Die Lagerung erfolgt bevorzugt in luftdicht geschlossenen Röhren aus Quarz, HDPE oder PP unter Überdruck.

Die Halogen- und Wasserstoffradikale werden im Rahmen der Erfindung durch Zersetzung von Halogenwasserstoff mittels UV-Licht erzeugt.

Vorteilhaft am erfindungsgemäßen Verfahren ist die Tatsache, dass die mit Luftschadstoffen belastete Dünnstaboberfläche vor der Abscheidung unter kontrollierten Bedingungen gereinigt wird.

Dotierstoffe werden durch Radikalreaktionen als flüchtige Halogenide (z.B. PC1₃ , BC1₃ , AsCl₃) und Hydride PH₃ , BH₃, B₂H₆, AsH₃) aus dem Reaktor entfernt. Eine Mischung z.B. aus HBr-HCl oder HJ-HCL wird bei niederen Temperaturen in H₂-Atmosphäre mit UV (z.B. der Wellenlänge 200-400 nm, bevorzugt 254 nm) bestrahlt, um die Dünnstäbe vor der Abscheidung zu reinigen und zu passivieren.

Die Chlor- und Wasserstoff-Radikale entfernen den letzten Rest der Bor-, Phosphor-, Aluminium- und Arsenspuren von der Silicium-Oberfläche.

Wenn die gereinigten Dünnstäbe anschließend nicht sofort eingesetzt werden, werden die derart gereinigten Dünnstäbe in gasdicht geschlossenen Röhren aus Quarz, HDPE oder PP unter Inertgas-Überdruck wie z. B. CO₂, N₂- oder Argon-Überdruck gelagert, um geringere Dotierstoffverunreinigung der abgeschiedenen Siliciumstäbe zu erzielen.

Niedrige Dotierstoffkonzentration in den abgeschiedenen Siliciumstäben ist ein wichtiges Qualitätskriterium für die weitere Verarbeitung der Siliciumstäbe nach dem Zonenzieh- und Tiegelziehverfahren zu versetzungsfreien Einkristallen.

Insbesondere eine niedrige Dotierstoffkonzentration in den Siliciumrohstäben ist notwendig zur Herstellung von Einkristallen mit gezielt eingestellten und konstanten Widerstandswerten.

Weiterhin sind höchstreine Dünnstäbe wichtig für hohe versetzungsfreie FZ-Ausbeuten mit hohem Widerstand.

Die Reaktion der erzeugten Halogen- und Wasserstoffradikale mit Aluminium-, Bor-, Phosphor- und As-haltigen Oberflächenverunreinigungen zu flüchtigen Halogeniden und Hydriden ist für das Gelingen der Erfindung wesentlich.

Die Grundlagen des Siemens-Prozesses sind detailliert beschrieben in der DE 10 2006 037 020 A1.

DE 10 2006 037 020 A1 zufolge wird ab dem Öffnen des Abscheidereaktors zum Ausbau eines ersten Trägerkörpers mit abgeschiedenem Silicium bis zum Schließen des Reaktors zum Abscheiden von Silicium auf einem zweiten Trägerkörper ein Inertgas durch die Zuführleitung und die Abführleitung hindurch in den geöffneten Reaktor eingeführt.

Das erfindungsgemäße Verfahren verfeinert die Produkteigenschaften durch zusätzliche Oberflächenreinigung der Dünnstäbe nach Inertisierung des Reaktors.

Die Erfindung wird im Folgenden anhand einer Figur veranschaulicht.

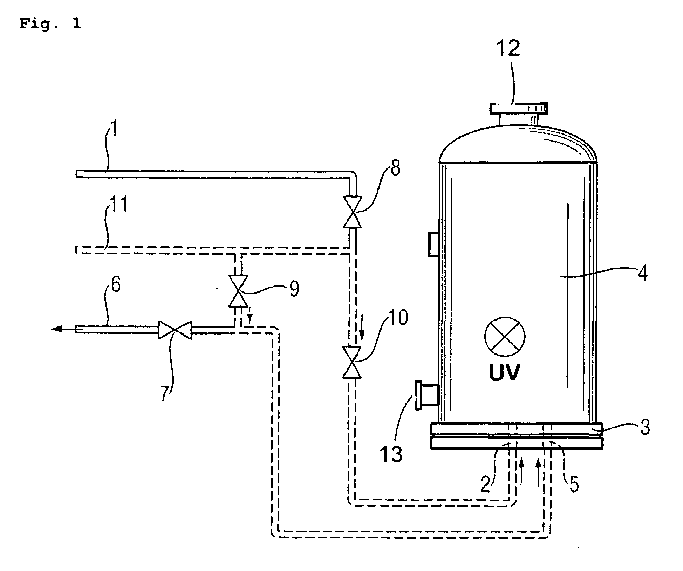

**Fig. 1** zeigt schematisch den Aufbau einer Vorrichtung zur Durchführung des Verfahrens.

Es handelt sich um den typischen Aufbau eines Siemens-Reaktors.

Ein solcher Reaktor umfasst eine Zuführleitung für ein Reaktionsgas 1 mit einem Absperrventil 8, welche über eine Zuführöffnung 2 durch die Bodenplatte 3 in einen Reaktor 4 führt, sowie eine Abführleitung für ein Abgas 6, welche durch eine Abführöffnung 5 in der Bodenplatte 3 des Reaktors 4 über ein Absperrventil 7 ins Freie oder zu einer Aufbereitung führt, dadurch gekennzeichnet, dass in die Zuleitung 1 nach dem Absperrventil 8 eine Inertgasleitung 11 mündet, welche durch ein Absperrventil 10 regelbar ist und in die Ableitung 6 vor dem Absperrventil 7 eine Inertgasleitung 11 mündet, welche durch ein Absperrventil 9 regelbar ist.

### Vergleichsbeispiel

Während des Chargenwechsels bzw. Einbauen der Dünnstäbe wurden Zu- und Abführleitungen sowie die Glocke in offenem Zustand mit Inertgas (Stickstoff) gespült.

Die Abscheidung selbst erfolgte aus Trichlorsilan (TCS) wie in DE 12 09 113 bzw. DE 196 08 885 ("Zündung") beschrieben.

Nachdem die Polystäbe auf den gewünschten Zieldurchmesser gewachsen sind, wurde die Zufuhr von Trichlorsilan unterbrochen und der Reaktor auf Raumtemperatur gekühlt und inertisiert.

Nach Ausbau wurden Proben aus den fertigen Polystäben gem. SEMI MF 1723-1104 (23.10.2003) präpariert und entsprechend der Norm SEMI MF 397-02 (spez. Widerstand, 22.10.2003) und SEMI MF 1389-0704 (P-Gehalt per Photolumineszenz, 22.10.2003) auf Dotierstoffe geprüft.

Der spez. Widerstand lag bei 980 Ohmcm mit einem P-Gehalt von 33 ppta. Die Steigung mᵣₕₒ war 150 Ohmcm/mm (Definition mᵣₕₒ, vgl. DE 10 2006 037 020 A1 [0010] - [0012]) .

### Beispiel

Der Reaktor wird vorbereitet, wie in Beispiel 1.

Nachdem der Reaktor 4 wieder dicht zusammengebaut ist, wird eine UV-Lampe (z.B. Ren-Ray 3SC-9 oder Hanovia SC2537) durch den Flansch 12 oder durch das Schauglas 13 abgedichtet eingeführt.

Anschließend wird nach Schließung des Ventils 9 und Öffnung des Ventils 8 bei offenem Ventil 10 über die Reaktionsgasleitung 1 eine Mischung von HBr - HCl -H₂ in einem Volumenverhältnis von 0,00001 _{:} 0,1 _{:} 0,9 bis 0,01 _{:} 0,09 : 0,9 bei atm. Druck mit einem Volumenstrom von 85 m³/h eingeleitet und über die Abgasleitung 6 entsorgt.

Das strömende HX-H₂ Gemisch wird mit der UV-Lampe bestrahlt und die Dünnstaboberflächen 30 Min lang mit dem bestrahlten Gemisch bei RT behandelt.

Nach dieser Behandlung wird Ventil 8 geschlossen, die UV-Lampe unter N₂ Inertgasstrom aus dem Reaktor 4 entfernt und der Reaktor 4 über die Inertgasleitung 11 und Abgasleitung 6 wieder inertisiert.

In diesem Zustand wird dann die Abscheidung ausgeführt, wie im Beispiel 1 beschrieben.

Die ausgebauten Stäbe zeigten einen spez. Widerstand >1100 Ohmcm mit einem P-Gehalt <26 ppta. Die Steigungswerte mᵣₕₒ lagen >150 Ohmcm/mm.

## Patentansprüche

1. Verfahren zur Herstellung von polykristallinen Siliciumstäben durch Abscheiden von Silicium auf wenigstens einem Dünnstab in einem Reaktor, wobei vor der Siliciumabscheidung Halogenwasserstoff bei einer Dünnstabtemperatur von 400-1000°C in den Reaktor enthaltend wenigstens einen Dünnstab eingeleitet, mittels UV-Licht bestrahlt wird, wodurch Halogen- und Wasserstoffradikale entstehen und die sich bildenden flüchtigen Halogenide und Hydride aus dem Reaktor entfernt werden.

2. Verfahren nach Anspruch 1, wobei nach Entfernung der flüchtigen Halogenide und Hydride Silicium auf dem wenigstens einen Dünnstab abgeschieden wird.

3. Verfahren nach Anspruch 1, wobei nach Entfernung der flüchtigen Halogenide und Hydride der wenigstens eine Dünnstab zunächst aus dem Reaktor entfernt und in einer luftdicht geschlossenen Röhre beinhaltend eine inerte Atmosphäre gelagert wird und zu einem späteren Zeitpunkt wieder in einen Reaktor eingebracht wird, um Silicium auf dem wenigsten einen Dünnstab abzuscheiden.

4. Verfahren nach einem der Ansprüche 1 bis 3, wobei Reaktor und Gaszufuhr- und Abfuhrleitungen im Reaktor vor Einleiten von Halogenwasserstoff mittels eines inerten Gases gespült werden.

5. Verfahren nach einem der Ansprüche 1 bis 4, wobei die Bestrahlung mittels einer UV-Lampe erfolgt, die durch einen Flansch oder ein Schauglas abgedichtet in den Reaktor eingeführt wird.

6. Verfahren nach einem der Ansprüche 1 bis 5, wobei nach Entfernung der flüchtigen Halogenide und Hydride aus dem Reaktor und vor einer Abscheidung von Silicium auf dem wenigstens einen Dünnstab eine Spülung von Reaktor und Gasleitungen mittels eines inerten Gases erfolgt.

## Claims

1. Method for producing polycrystalline silicon rods by deposition of silicon on at least one thin rod in a reactor, wherein, before the silicon deposition, hydrogen halide at a thin rod temperature of 400 - 1000°C is introduced into the reactor containing at least one thin rod and is irradiated by means of UV light, as a result of which halogen and hydrogen radicals arise and the volatile halides and hydrides that form are removed from the reactor.

2. Method according to Claim 1, wherein, after the removal of the volatile halides and hydrides, silicon is deposited on the at least one thin rod.

3. Method according to Claim 1, wherein, after the removal of the volatile halides and hydrides, the at least one thin rod is first removed from the reactor and stored in a tube closed in an airtight fashion and comprising an inert atmosphere and, at a later point in time, is introduced into a reactor again in order to deposit silicon on the at least one thin rod.

4. Method according to any of Claims 1 to 3, wherein reactor and gas feed and discharge lines in the reactor are purged by means of an inert gas before the introduction of hydrogen halide.

5. Method according to any of Claims 1 to 4, wherein the irradiation is effected by means of a UV lamp which is inserted into the reactor in a manner sealed by a flange or a viewing glass.

6. Method according to any of Claims 1 to 5, wherein, after the removal of the volatile halides and hydrides from the reactor and before a deposition of silicon on the at least one thin rod, reactor and gas lines are purged by means of an inert gas.

## Revendications

1. Procédé de fabrication de barreaux de silicium poly-cristallin par dépôt de silicium sur au moins un barreau mince placé dans un réacteur, de l'halogénure d'hydrogène étant avant le dépôt de silicium introduit dans le réacteur contenant au moins un barreau mince, la température du barreau mince étant comprise entre 400 et 1 000°C, l'halogénure d'hydrogène étant irradié par de la lumière UV, ce qui forme des radicaux d'halogène et des radicaux d'hydrogène, les halogénures et hydrures volatils se formant ainsi étant extraits du réacteur.

2. Procédé selon la revendication 1, dans lequel du silicium est déposé sur le ou les barreaux minces après l'extraction des halogénures et hydrures volatils.

3. Procédé selon la revendication 1, dans lequel, après l'extraction des halogénures et hydrures volatils, le ou les barreaux minces sont d'abord retirés du réacteur et sont entreposés dans un tube fermé de manière étanche à l'air et contenant une atmosphère inerte, pour être introduits de nouveau dans un réacteur à un instant ultérieur pour déposer du silicium sur le ou les barreaux minces.

4. Procédé selon l'une des revendications 1 à 3, dans lequel le réacteur et les conduits d'amenée et d'évacuation de gaz dans le réacteur sont balayés par un gaz inerte avant l'introduction de l'halogénure d'hydrogène.

5. Procédé selon l'une des revendications 1 à 4, dans lequel l'irradiation s'effectue au moyen d'une lampe à UV qui est insérée dans le réacteur de manière étanche par l'intermédiaire d'une bride ou d'une fenêtre d'observation.

6. Procédé selon l'une des revendications 1 à 5, dans lequel le réacteur et les conduits de gaz sont balayés par un gaz inerte après l'extraction des halogénures et hydrures volatils hors du réacteur et avant un dépôt de silicium sur le ou les barreaux minces.
